(19) Europäisches Patentamt
European Patent Office
Office européen des brevets

(11) **EP 4 539 051 A1**

(12) **EUROPEAN PATENT APPLICATION**
published in accordance with Art. 153(4) EPC

(43) Date of publication:
**16.04.2025 Bulletin 2025/16**

(21) Application number: **23829760.0**

(22) Date of filing: **15.05.2023**

(51) International Patent Classification (IPC):
**G11C 11/22** *(2006.01)*

(52) Cooperative Patent Classification (CPC):
**G11C 11/22**

(86) International application number:
**PCT/CN2023/094138**

(87) International publication number:
**WO 2024/001574 (04.01.2024 Gazette 2024/01)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **29.06.2022 CN 202210747729**

(71) Applicant: **Huawei Technologies Co., Ltd.
Shenzhen, Guangdong 518129 (CN)**

(72) Inventors:
• **XU, Liang**
**Shenzhen, Guangdong 518129 (CN)**
• **BU, Sitong**
**Shenzhen, Guangdong 518129 (CN)**
• **FANG, Yichen**
**Shenzhen, Guangdong 518129 (CN)**
• **XU, Jeffrey Junhao**
**Shenzhen, Guangdong 518129 (CN)**

(74) Representative: **Thun, Clemens
Mitscherlich PartmbB
Patent- und Rechtsanwälte
Karlstraße 7
80333 München (DE)**

(54) **MEMORY AND ACCESS METHOD**

(57) Embodiments of this application provide a memory. The memory includes a first memory cell, a sense amplifier, a first bit line, a second bit line, a first isolator, a second isolator, a third isolator, a fourth isolator, and a controller. The first bit line is connected to the first memory cell and a first output of the sense amplifier. The second bit line is connected to a second output of the sense amplifier. The first isolator is connected to the first bit line and the first output of the sense amplifier. The second isolator is connected to the second bit line and the second output of the sense amplifier. The third isolator is connected to the first bit line and the second output of the sense amplifier. The fourth isolator is connected to the second bit line and the first output of the sense amplifier. According to the technical solutions of this application, unilateral disturbance in an entire access period of a memory cell can be converted into bilateral disturbance, thereby reducing impact of the unilateral disturbance on a capacitor.

FIG. 8

EP 4 539 051 A1

## Description

This application claims priority to Chinese Patent Application No. 202210747729.X, filed with the China National Intellectual Property Administration on June 29, 2022 and entitled "MEMORY AND ACCESS METHOD", which is incorporated herein by reference in its entirety.

## TECHNICAL FIELD

Embodiments of this application relate to the semiconductor field, and specifically, to a memory and an access method.

## BACKGROUND

In recent years, requirements in emerging application scenarios such as artificial intelligence and edge computing are increasing, posing challenges to a capacity, power consumption, and a rate of a conventional memory, and driving continuous development of new memories. A ferroelectric memory, as a new memory, is superior in non-volatility, high read/write speed and low power consumption. A structure of m transistors and n capacitors (m transistors and n capacitors, mTnC) greatly improves storage density of the ferroelectric memory. However, at present, the ferroelectric memory adopts a dynamic random access memory like (dynamic random access memory like, DRAM-like) reading manner. As a result, semi-select voltage disturbance (disturbance), especially unilateral disturbance, will occur in a ferroelectric capacitor, which seriously reduces data reliability of the memory and increases system power consumption.

Therefore, how to reduce the unilateral disturbance to the capacitor and improve the data storage reliability is an urgent problem to be resolved.

## SUMMARY

Embodiments of this application provide a memory and an access method, so that unilateral disturbance in an entire access period of a memory cell can be converted into bilateral disturbance, thereby reducing impact of the unilateral disturbance on a capacitor.

According to a first aspect, a memory is provided, including: a first memory cell, where the first memory cell is a memory cell selected for a read operation or a write operation; a sense amplifier, a first bit line, and a second bit line, where the first bit line is connected to the first memory cell and a first output of the sense amplifier, and the second bit line is connected to a second output of the sense amplifier; a first isolator, a second isolator, a third isolator, and a fourth isolator, where the first isolator is connected to the first bit line and the first output of the sense amplifier, the second isolator is connected to the second bit line and the second output of the sense amplifier, the third isolator is connected to the first bit line and the second output of the sense amplifier, and the fourth isolator is connected to the second bit line and the first output of the sense amplifier; and a controller, configured to: before writeback of the first memory cell is completed, turn on the first isolator and the second isolator, and turn off the third isolator and the fourth isolator; and after the writeback of the first memory cell is completed, turn off the first isolator and the second isolator, and turn on the third isolator and the fourth isolator.

The memory in this embodiment of this application includes the first isolator, the second isolator, the third isolator, and the fourth isolator. The four isolators can exchange voltages of the first bit line and the second bit line after the writeback of the first memory cell is completed, to form an exchange phase, so that unilateral disturbance in an entire access period of the memory cell is converted into bilateral disturbance, thereby reducing impact of the unilateral disturbance on a capacitor.

It should be understood that the first memory cell may be any memory cell in a memory array. The first memory cell provided in this application is a structure of m transistors and n capacitors (m transistors and n capacitors, mTnC), that is, the first memory cell includes the m transistors and the n capacitors, where m≥1, and n≥2. For example, the memory may be a ferroelectric memory, or may be a memory that is made of another material and that has a unilateral disturbance problem.

It should be understood that the first output and the second output of the sense amplifier include output ports. The sense amplifier can be connected to a plurality of memory cells through bit lines.

It should be understood that both the first bit line and the second bit line are connected to the same sense amplifier, and it may be considered that the second bit line and the first bit line share a readout circuit.

Optionally, the first bit line may be indicated by BL, and the second bit line may be indicated by BLN. At least one first isolator may be arranged on the first bit line, and the first isolator is connected to the first bit line and the first output of the sense amplifier. At least one second isolator may be arranged on the second bit line, and the second isolator is connected to the second bit line and the second output of the sense amplifier. The third isolator is connected to the first bit line and the second output of the sense amplifier, and the fourth isolator is connected to the second bit line and the first output of the sense amplifier. For example, the first bit line and the second bit line are connected through a first conducting wire, and the third isolator and the fourth isolator are located on the first conducting wire.

The sense amplifier is configured to amplify voltages of the BL and the BLN. For example, the sense amplifier includes a sense-amplifier n-field effect tube control (sense-amplifier n-fet control, SAN) and a sense-amplifier p-fet control (sense-amplifier p-fet control, SAP). The SAN and the SAP supply power to the sense amplifier. Power supply values of the SAN and the SAP determine voltage states to which the voltages of the BL and the BLN are amplified by the sense amplifier. For example, when voltages of the SAN and the SAP are respectively 0 and Vw, after the sense amplifier completes operation, the voltages of the BL and the BLN are pulled to 0 or Vw; and when the voltages of the SAN and the SAP are respectively Vw and Vw/2, after the sense amplifier completes operation, the voltages of the BL and the BLN are pulled to Vw or Vw/2, where Vw represents a write operation voltage of the first memory cell.

It should be understood that the controller may provide a control signal. Before the writeback of the first memory cell is completed, the first isolator and the second isolator are turned on, and the third isolator and the fourth isolator are turned off. After the writeback of the first memory cell is completed, the first isolator and the second isolator are turned off, and the third isolator and the fourth isolator are turned on.

Optionally, the sense amplifier, the first isolator, the second isolator, the third isolator, and the fourth isolator may be integrated into the controller. This is not limited in this application.

It should be understood that turning on the isolator indicates connecting lines at both ends of the isolator, and turning off the isolator indicates disconnecting the lines at both ends of the isolator.

It should be understood that the writeback of the first memory cell includes writeback of a selected capacitor in the first memory cell.

In this embodiment of this application, before the writeback of the first memory cell is completed, the first isolator and the second isolator are turned on, and the third isolator and the fourth isolator are turned off. After the writeback is completed, the first isolator and the second isolator are turned off, and the third isolator and the fourth isolator are turned on, so that the voltages of the BL and the BLN can be exchanged to form an exchange phase, thereby converting unilateral disturbance in an entire access period of the memory cell into bilateral disturbance, and reducing impact of the unilateral disturbance on the capacitor.

With reference to the first aspect, in a possible implementation, if before the writeback is completed, a voltage of the first bit line is a first positive voltage, and a voltage of the second bit line is a second positive voltage, after the writeback is completed, the voltage of the first bit line is the second positive voltage, and the voltage of the second bit line is the first positive voltage; or if before the writeback is completed, a voltage of the first bit line is the second positive voltage, and a voltage of the second bit line is the first positive voltage, after the writeback is completed, the voltage of the first bit line is the first positive voltage, and the voltage of the second bit line is the second positive voltage.

Optionally, the first positive voltage is equal to Vw/2, and the second positive voltage is equal to Vw, where Vw represents a write operation voltage of the first memory cell.

For example, if before the writeback is completed, the voltage of the first bit line is Vw/2, and the voltage of the second bit line is Vw, after the writeback is completed, the voltage of the first bit line is Vw, and the voltage of the second bit line is Vw/2; and if before the writeback is completed, the voltage of the first bit line is Vw, and the voltage of the second bit line is Vw/2, after the writeback is completed, the voltage of the first bit line is Vw/2, and the voltage of the second bit line is Vw.

The memory in this embodiment of this application includes the first isolator, the second isolator, the third isolator, and the fourth isolator. The four isolators can exchange the voltages of the first bit line and the second bit line after the writeback of the first memory cell is completed, to form the exchange phase, so that the unilateral disturbance in the entire access period of the memory cell is converted into the bilateral disturbance, thereby reducing the impact of the unilateral disturbance on the capacitor.

With reference to the first aspect, in a possible implementation, the first isolator is located between the third isolator and the sense amplifier, and the second isolator is located between the fourth isolator and the sense amplifier.

The memory in this embodiment of this application includes the first isolator, the second isolator, the third isolator, and the fourth isolator. The four isolators can exchange the voltages of the first bit line and the second bit line after the writeback of the first memory cell is completed, to form the exchange phase, so that the unilateral disturbance in the entire access period of the memory cell is converted into the bilateral disturbance, thereby reducing the impact of the unilateral disturbance on the capacitor.

With reference to the first aspect, in a possible implementation, after the writeback is completed, a voltage of a floating gate of the first memory cell is the same as a voltage of the first bit line, and first electrode plates of a plurality of capacitors of the first memory cell are connected to the floating gate.

It should be understood that the first memory cell includes the plurality of capacitors, a first electrode plate of each capacitor is connected to the floating gate (floating gate, FG), a second electrode plate is connected to the plate line, and the floating gate is connected to the first bit line. After the writeback is completed, the voltages of the first bit line and the second bit line are exchanged. Because the floating gate is connected to the first bit line, the voltage of the floating gate of the first memory cell is the same as the voltage of the first bit line.

The memory in this embodiment of this application includes the first isolator, the second isolator, the third isolator, and the fourth isolator. The four isolators can exchange the voltages of the first bit line and the second bit line after the writeback of the first memory cell is completed, to form the exchange phase, so that the unilateral disturbance in the entire access period of the memory cell is converted into the bilateral disturbance, thereby reducing the impact of the unilateral disturbance on the capacitor.

With reference to the first aspect, in a possible implementation, the first isolator and the second isolator each is an isolation (isolation, ISO) transistor.

With reference to the first aspect, in a possible implementation, the first bit line and the second bit line are connected through the first conducting wire, the first isolator is located on the first bit line, the second isolator is located on the second bit line, and the third isolator and the fourth isolator are located on the first conducting wire.

The memory in this embodiment of this application includes the first isolator, the second isolator, the third isolator, and the fourth isolator. The four isolators can exchange the voltages of the first bit line and the second bit line after the writeback of the first memory cell is completed, to form the exchange phase, so that the unilateral disturbance in the entire access period of the memory cell is converted into the bilateral disturbance, thereby reducing the impact of the unilateral disturbance on the capacitor.

According to a second aspect, an integrated circuit is provided, including the memory according to any one of the first aspect or the possible implementations of the first aspect.

According to a third aspect, an electronic device is provided, including a circuit board and the memory according to the first aspect. The memory is disposed on the circuit board and is electrically connected to the circuit board.

According to a fourth aspect, a memory access method is provided. The method is applied to a memory including a first memory cell, a sense amplifier, a first bit line, a second bit line, a first isolator, a second isolator, a third isolator, a fourth isolator, and a controller. The first memory cell is a memory cell selected for a read operation or a write operation. The first bit line is connected to the first memory cell and a first output of the sense amplifier. The second bit line is connected to a second output of the sense amplifier. The first isolator is connected to the first bit line and the first output of the sense amplifier. The second isolator is connected to the second bit line and the second output of the sense amplifier. The third isolator is connected to the first bit line and the second output of the sense amplifier. The fourth isolator is connected to the second bit line and the first output of the sense amplifier. The method includes: before writeback of the first memory cell is completed, the controller turns on the first isolator and the second isolator, and turns off the third isolator and the fourth isolator; and after the writeback of the first memory cell is completed, the controller turns off the first isolator and the second isolator, and turns on the third isolator and the fourth isolator.

It should be understood that the first memory cell may be any memory cell in a memory array. The first memory cell provided in this application is a structure of m transistors and n capacitors (m transistors and n capacitors, mTnC), that is, the first memory cell includes the m transistors and the n capacitors, where m≥1, and n≥2. For example, the memory may be a ferroelectric memory, or may be a memory that is made of another material and that has a unilateral disturbance problem.

It should be understood that the first output and the second output of the sense amplifier include output ports.

It should be understood that both the first bit line and the second bit line are connected to the same sense amplifier, and it may be considered that the second bit line and the first bit line share a readout circuit.

Optionally, the first bit line may be indicated by BL, and the second bit line may be indicated by BLN. At least one first isolator may be arranged on the first bit line, and the first isolator is connected to the first bit line and the first output of the sense amplifier. At least one second isolator may be arranged on the second bit line, and the second isolator is connected to the second bit line and the second output of the sense amplifier. The third isolator is connected to the first bit line and the second output of the sense amplifier, and the fourth isolator is connected to the second bit line and the first output of the sense amplifier. For example, the first bit line and the second bit line are connected through a first conducting wire, and the third isolator and the fourth isolator are arranged on the first conducting wire.

It should be understood that turning on the isolator indicates connecting lines at both ends of the isolator, and turning off the isolator indicates disconnecting the lines at both ends of the isolator.

The memory in this embodiment of this application includes the first isolator, the second isolator, the third isolator, and the fourth isolator. The four isolators can exchange voltages of the first bit line and the second bit line after the writeback of the first memory cell is completed, to form an exchange phase, so that unilateral disturbance in an entire access period of the memory cell is converted into bilateral disturbance, thereby reducing impact of the unilateral disturbance on a capacitor.

With reference to the fourth aspect, in a possible implementation, if before the writeback is completed, a voltage of the first bit line is a first positive voltage, and a voltage of the second bit line is a second positive voltage, after the writeback is completed, the voltage of the first bit line is the second positive voltage, and the voltage of the second bit line is the first positive voltage; or if before the writeback is completed, a voltage of the first bit line is the second positive voltage, and a voltage of the second bit line is the first positive voltage, after the writeback is completed, the voltage of the first bit line is the first positive voltage, and the voltage of the second bit line is the second positive voltage.

With reference to the fourth aspect, in a possible implementation, the first positive voltage is equal to Vw/2, and the second positive voltage is equal to Vw, where Vw represents a write operation voltage of the first memory cell.

The memory in this embodiment of this application includes the first isolator, the second isolator, the third isolator, and the fourth isolator. The four isolators can exchange the voltages of the first bit line and the second bit line after the writeback of the first memory cell is completed, to form the exchange phase, so that the unilateral disturbance in the entire access period of the memory cell is converted into the bilateral disturbance, thereby reducing the impact of the unilateral disturbance on the capacitor.

With reference to the fourth aspect, in a possible implementation, after the writeback is completed, a voltage of a floating gate of the first memory cell is the same as a voltage of the first bit line, and first electrode plates of a plurality of capacitors of the first memory cell are connected to the floating gate.

It should be understood that the first memory cell includes the plurality of capacitors, a first electrode plate of each capacitor is connected to the floating gate (floating gate, FG), a second electrode plate is connected to the plate line, and the floating gate is connected to the first bit line. After the writeback is completed, the voltages of the first bit line and the second bit line are exchanged. Because the floating gate is connected to the first bit line, the voltage of the floating gate of the first memory cell is the same as the voltage of the first bit line.

The memory in this embodiment of this application includes the first isolator, the second isolator, the third isolator, and the fourth isolator. The four isolators can exchange the voltages of the first bit line and the second bit line after the writeback of the first memory cell is completed, to form the exchange phase, so that the unilateral disturbance in the entire access period of the memory cell is converted into the bilateral disturbance, thereby reducing the impact of the unilateral disturbance on the capacitor.

## BRIEF DESCRIPTION OF DRAWINGS

FIG. 1 is a diagram of a typical mTnC memory array structure;

FIG. 2 is a diagram of a structure of a memory according to the conventional technology;

FIG. 3 is a diagram of a waveform of a read/write operation of a memory according to the conventional technology;

FIG. 4 is a diagram of a scenario in which a ferroelectric capacitor is disturbed according to an embodiment of this application;

FIG. 5 is a diagram of a representation of unilateral disturbance according to an embodiment of this application;

FIG. 6 is a diagram of a structure of another memory according to the conventional technology;

FIG. 7 is a diagram of a structure of a memory according to an embodiment of this application;

FIG. 8 is a diagram of a structure of another memory according to an embodiment of this application; and

FIG. 9 is a diagram of a waveform of a read/write operation of a memory according to an embodiment of this application.

## DESCRIPTION OF EMBODIMENTS

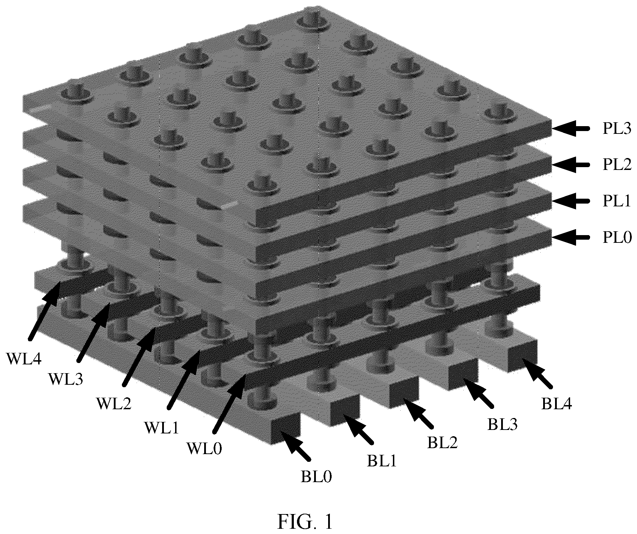

FIG. 1 is a diagram of a typical mTnC memory array structure.

Each memory cell in the memory array shown in FIG. 1 includes m transistors and n capacitors, where $m \geq 1$, and $n \geq 2$. For example, the memory array includes five word lines (word lines, WLs), five bit lines (bit lines, BLs), and four plate lines (plate lines, PLs). The word lines WL0 to WL4 are arranged in a row direction, and each word line WL is connected to a gate of an access transistor in a same row of memory cells. The bit lines BL0 to BL4 are arranged in a column direction, and each bit line BL is connected to a source end of an access transistor in a same column of memory cells. The plate lines PL0 to PL3 are distributed at different metal layers. It should be understood that marked locations of the WLs, the PLs, and the BLs in the figure are locations at layers of distribution of the interconnected lines.

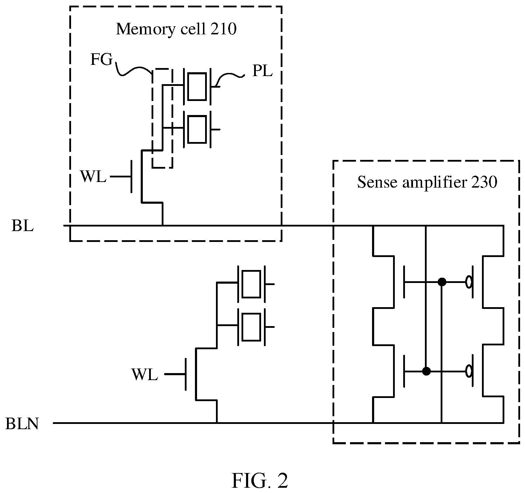

FIG. 2 is a diagram of a structure of a memory according to the conventional technology.

A WL indicates a word line, a PL indicates a plate line, a BL and a BLN indicate bit lines, and an FG indicates a floating gate (floating gate, FG). In the figure, a memory cell 210 includes one transistor and a plurality of ferroelectric capacitors. A lower electrode plate of the ferroelectric capacitor is connected to an FG, and an upper electrode plate of the ferroelectric capacitor is connected to a PL. The sense amplifier 230 is configured to amplify voltages of the BL and the BLN.

It should be understood that the BL and the BLN are for distinguishing between different bit lines in a memory array. For example, a bit line in which a selected memory cell is located is referred to as the BL, and a bit line that shares a readout circuit with the selected memory cell is referred to as the BLN. The name should not be construed as a limitation on this application.

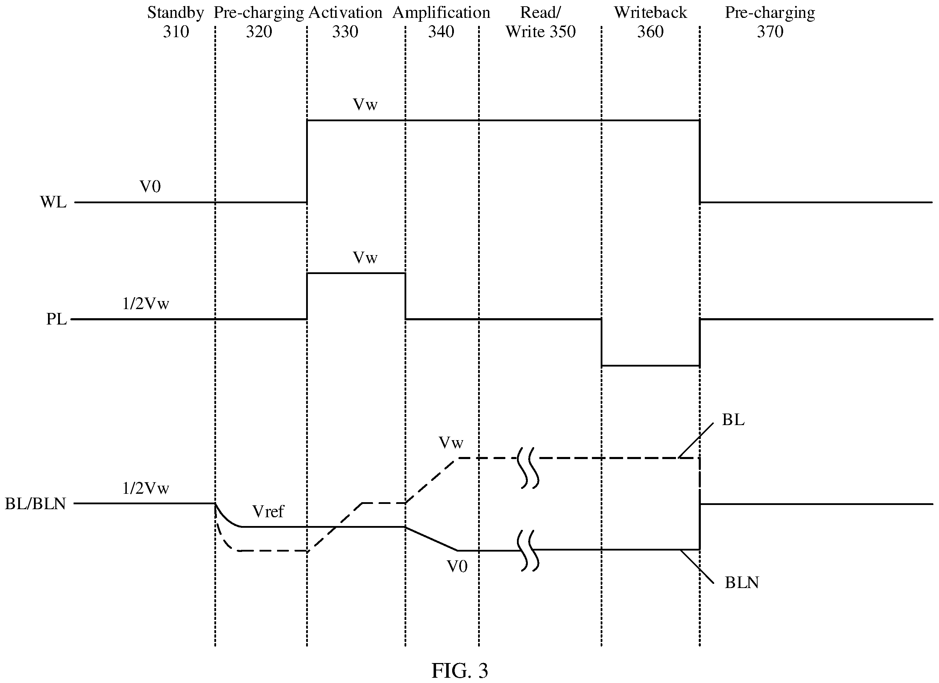

FIG. 3 is a diagram of a waveform of a read/write operation of a memory according to the conventional technology. The read/write operation in FIG. 3 corresponds to an array structure shown in FIG. 1, and mainly includes a standby phase 310, a pre-charging phase 320, an activation phase 330, an amplification phase 340, a read/write phase 350, and a writeback phase 360. A dashed line of a BL/BLN indicates a voltage change process on the BL in a read/write process when information stored on a ferroelectric capacitor is 1. A solid line of the BL/BLN indicates a voltage change process on the BLN when the information stored on the ferroelectric capacitor is 1.

Standby phase 310: In an initial standby phase, a WL is in a low voltage V0 state, a PL and the BL/BLN are in a semi-select voltage (1/2Vw) state, and a voltage of an FG is Vw/2. In this case, a voltage difference of the ferroelectric capacitor is 0. Vw indicates a write operation voltage. Under a voltage difference of Vw, a polarization state of the ferroelectric capacitor changes. V0 indicates that a voltage is 0 V

Pre-charging phase 320: A read/write command starts from the pre-charging phase, and a voltage of the BL is pulled down to V0, and a voltage of the BLN is pulled to a preset reference voltage value Vref.

Activation phase 330: A voltage of the WL is pulled up to Vw to turn on a gating transistor, the voltage (V0) of the BL is transferred to the FG, and after the BL enters a floating (floating) state, a voltage of the PL is pulled up to Vw. If information stored on the ferroelectric capacitor is 0, and a voltage difference between the PL and the FG is Vw, the voltage difference between the PL and the FG at two ends of the ferroelectric capacitor is still Vw during an activation operation. In this case, a polarization state of the ferroelectric capacitor does not change, no charge is released, and the voltages of the BL and the FG remain at V0. If the information stored on the ferroelectric capacitor is 1, and the voltage difference between the PL and the FG is -Vw, the voltage difference between the PL and the FG at the two ends of the ferroelectric capacitor is Vw during the activation operation. In this case, the polarization state of the ferroelectric capacitor changes, and the voltages of the FG and the BL increase to some extent due to charge release.

Amplification phase 340: In the amplification phase, the voltage of the BL is compared with the reference voltage Vref of the BLN, and the voltage of the BL is amplified by a sense amplifier (sense amplifier, SA) 230 to V0 or Vw. For example, if the voltage of the BL is less than the reference voltage Vref, the voltage of the BL is amplified to V0; or if the voltage of the BL is greater than the reference voltage Vref, the voltage of the BL is amplified to Vw.

Read/write phase 350: A continuous read/write phase is entered. If a read operation is performed, information stored on the BL is read; and if a write operation is performed, the information stored on the BL is rewritten.

Writeback phase 360: The read operation is destructive reading, which may affect the state of the ferroelectric capacitor. Therefore, after the read/write operation is completed, a writeback action is required to write original data to the memory cell again. Otherwise, an error may occur during next reading. In the writeback phase, the voltage of the PL is pulled down to V0, and information stored on the BL and the FG may be written back to the ferroelectric capacitor.

Pre-charging phase 370: The voltages of the BL and the FG are restored to 1/2Vw, and then the voltage of the WL is pulled down to V0 to turn off the gating transistor, to complete one read/write operation.

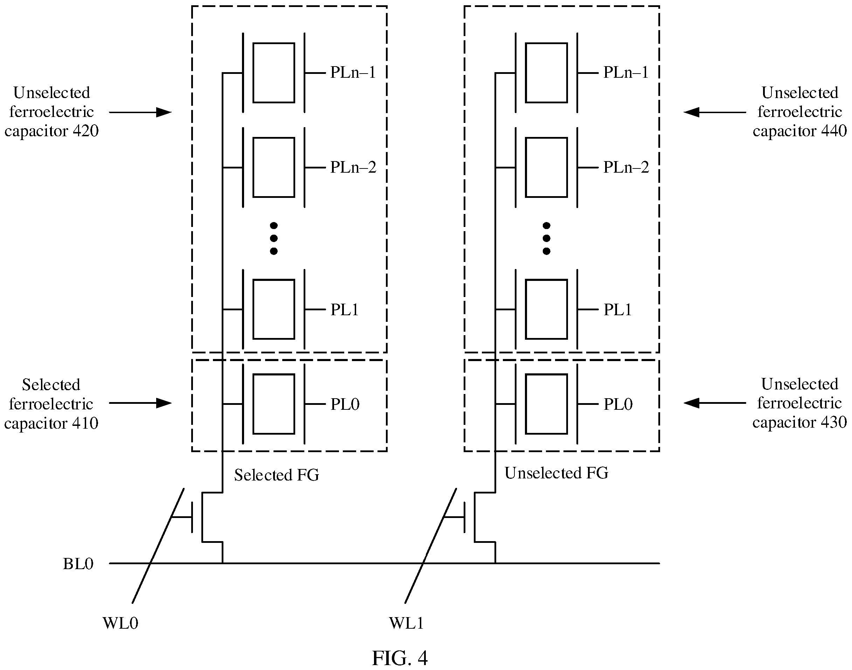

FIG. 4 is a diagram of a scenario in which a ferroelectric capacitor is disturbed according to an embodiment of this application.

Two memory cells shown in FIG. 4 are connected to a same bit line BL0. A first memory cell is connected to a word line WL0, and a second memory cell is connected to a word line WL1. Each memory cell includes one transistor and n ferroelectric capacitors, where $n \geq 2$. A capacitor of the first memory cell includes a selected ferroelectric capacitor 410 and an unselected ferroelectric capacitor 420, and a capacitor of the second memory cell includes an unselected ferroelectric capacitor 430 and an unselected ferroelectric capacitor 440. A lower electrode plate of an $i^{th}$ ferroelectric capacitor of each memory cell is connected to an FG, and an upper electrode plate of the $i^{th}$ ferroelectric capacitor is connected to PLi, where $0 \leq i < n$.

It should be understood that if either of an FG and a PL that correspond to a ferroelectric capacitor is not selected, it indicates that the ferroelectric capacitor is not selected. If both an FG and a PL that correspond to a ferroelectric capacitor are selected, it indicates that the ferroelectric capacitor is selected. In FIG. 4, both an FG and a PL of the selected ferroelectric capacitor 410 are selected, an FG of the unselected ferroelectric capacitor 420 is selected, a PL of the unselected ferroelectric capacitor 420 is not selected, an FG of the unselected ferroelectric capacitor 430 is not selected, a PL of the unselected ferroelectric capacitor 430 is selected, and neither an FG nor a PL of the unselected ferroelectric capacitor 440 is selected.

When m≥1 and n≥2, in an mTnC operation solution, for the unselected ferroelectric capacitor, there are the following two types of disturbance (disturbance) of semi-select voltage stress.

(1) Unilateral disturbance in the ferroelectric capacitor 420 of which the FG is selected and the PL is not selected.

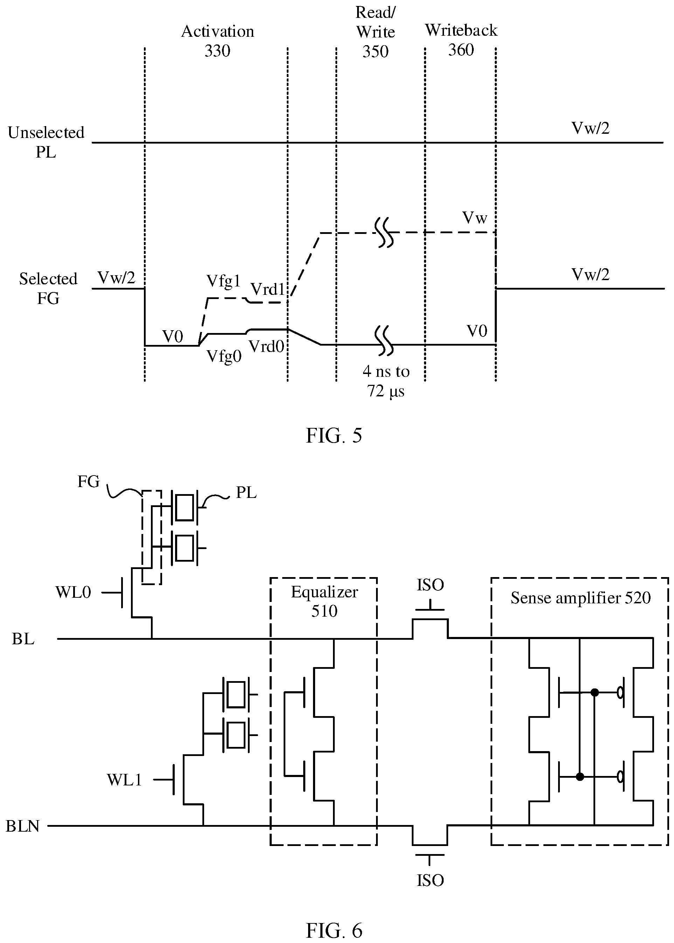

FIG. 5 is a diagram of a representation of the unilateral disturbance according to this embodiment of this application. During a complete read/write period, the ferroelectric capacitor 420 at the selected FG and the unselected PL has two types of stress unilateral disturbance.

A first type of unilateral disturbance is long-time stress unilateral disturbance, and the unilateral disturbance occurs in the read/write phase 350. Because the selected FG and the BL are pulled by the sense amplifier to Vw or V0, and a voltage of the PL connected to the unselected ferroelectric capacitor 420 is Vw/2, the unselected ferroelectric capacitor 420 on the selected FG has a unidirectional voltage difference of +Vw/2 or -Vw/2, and the voltage difference may last from 4 nanoseconds (ns) to 72 microseconds ($\mu$s).

A second type is short-time stress unilateral disturbance that occurs in the activation phase 330 and the writeback phase 360. A pre-charging voltage of the FG in the activation phase 330 is V0, and a voltage of the FG in the writeback phase 360 depends on writeback information (writeback "0" indicates that the voltage is V0, and writeback "1" indicates that the voltage is Vw). Duration of the two phases is related to flip time of the ferroelectric capacitor, and stress borne by the ferroelectric capacitor in both the two phases is short-time stress.

The two types of unilateral disturbance cause a loss of remanent polarization (remanent polarization, Pr) of the ferroelectric capacitor 420 at the selected FG and the unselected PL, and finally cause a loss of stored information.

(2) Bilateral disturbance in the ferroelectric capacitor 430 of which the FG is not selected and the PL is selected.

In a complete read/write period, a voltage of the unselected FG is Vw/2. Because a voltage of the PL is Vw in the activation phase, and is V0 in the writeback phase, the unselected ferroelectric capacitor 430 bears a bidirectional voltage difference of $\pm$Vw/2 in a complete read/write operation period. Stress of the bilateral disturbance on the ferroelectric capacitor is symmetric, therefore, this scenario has little impact on the ferroelectric capacitor.

The unilateral disturbance seriously affects development of the mTnC ferroelectric memory. In addition to optimization of a ferroelectric material, there are some improvements in circuits and operations to resolve the unilateral disturbance problem of the ferroelectric capacitor in a complete access period.

FIG. 6 is a diagram of a structure of another memory according to the conventional technology.

In the technical solution shown in FIG. 6, two isolation (isolation, ISO) transistors are added to a circuit, to resolve unilateral disturbance caused by long-time stress borne by a ferroelectric capacitor at a selected FG and an unselected PL in a read/write phase 350. In a specific operation solution, the two ISO transistors are added between a sense amplifier 520 and an equalizer 510. After the sense amplifier 520 completes amplification, the two ISO transistors are turned off. In this case, information about the ferroelectric capacitor is sensed by the sense amplifier 520, and then a BL and the FG are pre-charged back to Vw/2 via the equalizer 510. In this case, because other unselected PLs on the selected FG are all in Vw/2, there is no voltage difference between two ends of the ferroelectric capacitor. In a writeback phase 360, the ISO transistors are turned on, and the FG is charged by the sense amplifier 520 to a voltage required for writeback, to complete the writeback.

The technical solution shown in FIG. 6 resolves the unilateral disturbance caused by the long-time stress in the read/write phase 350, but unilateral disturbance caused by short-time stress in an activation phase 330 and the writeback phase 360 still exists. As a quantity of row activation times increases, the unilateral disturbance caused by the short-time stress is accumulated, and a Pr loss of the ferroelectric capacitor is caused. Therefore, the unilateral disturbance problem needs to be urgently resolved.

The following describes technical solutions of embodiments in this application with reference to accompanying drawings. Clearly, described embodiments are some but not all of embodiments of this application. All other embodiments obtained by a person of ordinary skill in the art based on embodiments of this application without creative efforts shall fall within the protection scope of this application.

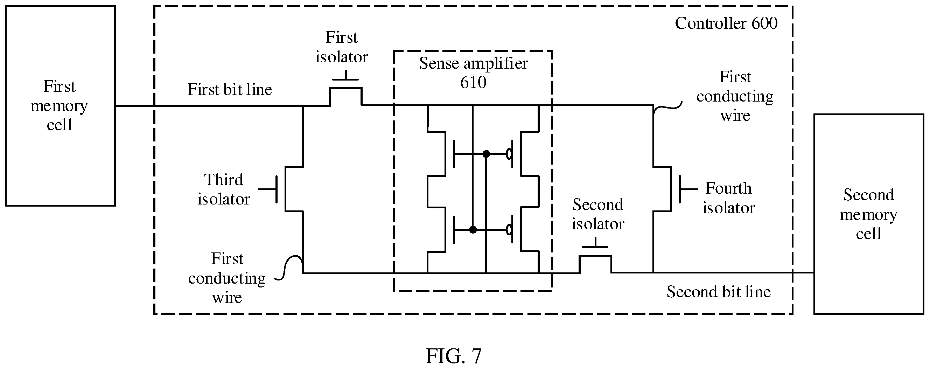

FIG. 7 is a diagram of a structure of a memory according to an embodiment of this application.

The memory provided in this application may include one or more memory arrays. A first memory cell and a second memory cell may be considered as any memory cell in the memory arrays, and each memory cell in the memory arrays includes a plurality of capacitors.

The memory provided in this application further includes a sense amplifier 610, a first isolator, a second isolator, a third isolator, and a fourth isolator. The first isolator is located on a first bit line and is connected to the first bit line and a first output of the sense amplifier. The second isolator is located on a second bit line and is connected to the second bit line and a second output of the sense amplifier. The first bit line and the second bit line are connected through a first conducting wire. The third isolator and the fourth isolator are located on two different first conducting wires. The third isolator is connected to the first bit line and the second output of the sense amplifier, and the fourth isolator is connected to the second bit line and the first output of the sense amplifier.

The first isolator, the second isolator, the third isolator, and the fourth isolator may be ISO transistors. Optionally, the first bit line may be indicated by BL, and the second bit line may be indicated by BLN.

The memory provided in this application further includes a controller 600. The controller 600 may provide a control signal. Before writeback of the first memory cell is completed, the first isolator and the second isolator are turned on, and the third isolator and the fourth isolator are turned off. After the writeback of the first memory cell is completed, the first isolator and the second isolator are turned off, and the third isolator and the fourth isolator are turned on.

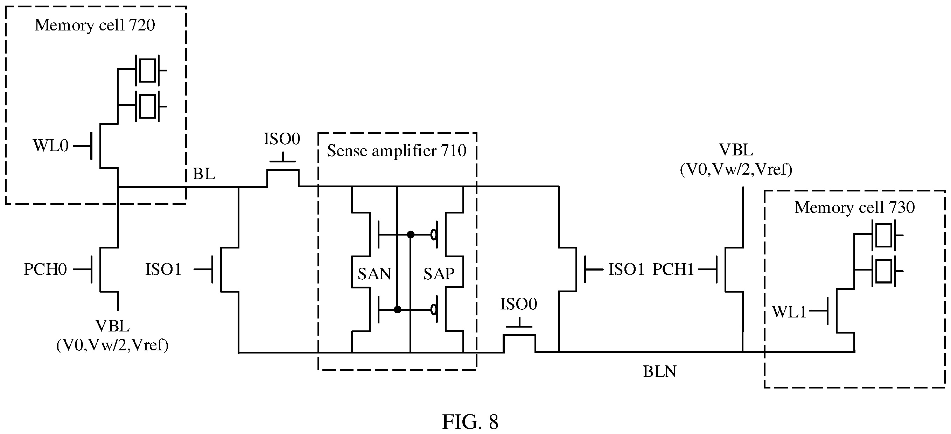

FIG. 8 is a diagram of a structure of another memory according to an embodiment of this application.

A gate of a memory cell 720 is connected to a word line WL0, and a source or a drain of the memory cell 720 is connected to a BL. A gate of a memory cell 730 is connected to a word line WL1, and a source or a drain of the memory cell 730 is connected to a BLN. PCH0 and PCH1 are pre-charge (pre-charge, PCH) signals, and are respectively used to pre-charge voltages for the BL and the BLN. The pre-charged voltages may include V0, Vw/2, and Vref. ISO0 is configured to control turn-on and turn-off of a sense amplifier 710 and connection and disconnection of the BL/BLN, and ISO1 is configured to control connection and disconnection of the BL and the BLN.

The sense amplifier 710 is configured to amplify voltages of BL and BLN. A sense-amplifier n-field effect tube control (sense-amplifier n-fet control, SAN) and a sense-amplifier p-fet control (sense-amplifier p-fet control, SAP) supply power to the sense amplifier 710. Power supply values of the SAN and the SAP determine voltage states to which the voltages of the BL and the BLN are amplified by the sense amplifier 710. For example, when voltages of the SAN and the SAP are respectively 0 and Vw, after the SA completes operation, the voltages of the BL and the BLN are pulled to 0 or Vw; and when the voltages of the SAN and the SAP are respectively Vw and Vw/2, after the SA completes operation, the voltages of the BL and the BLN are pulled to Vw or Vw/2.

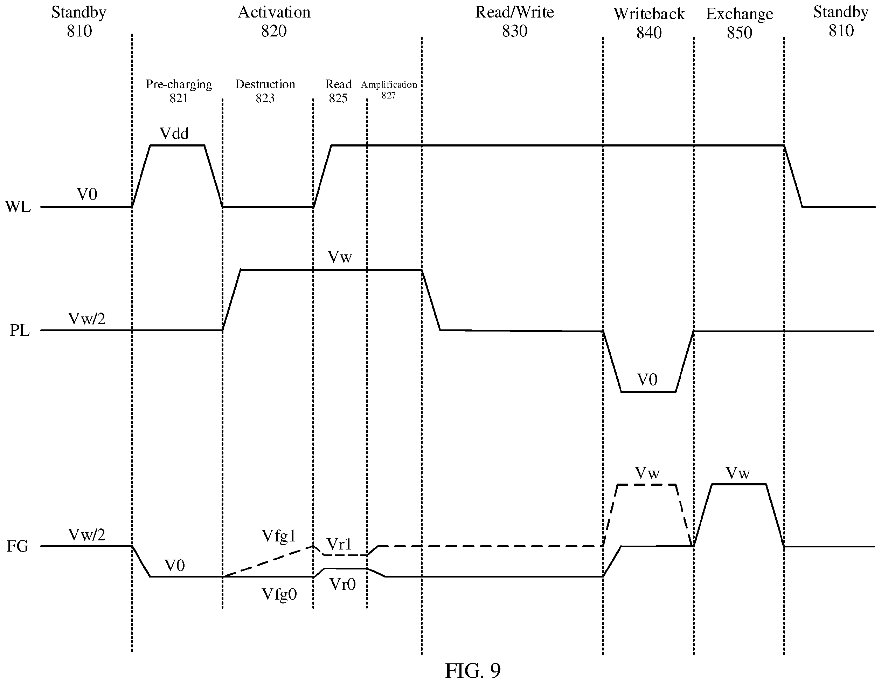

FIG. 9 is a diagram of a waveform of a read/write operation of a memory according to an embodiment of this application. The read/write operation shown in FIG. 9 corresponds to a structure of a memory array shown in FIG. 8. A dashed line of an FG indicates a voltage change process on the FG in a read/write process when information stored on a ferroelectric capacitor is 1. A solid line of the FG indicates a voltage change process on the FG when the information stored on the ferroelectric capacitor is 0.

The read/write operation provided in this embodiment of this application mainly includes a standby phase 810, an activation phase 820, a read/write phase 830, a writeback phase 840, and an exchange phase 850. The activation phase 820 includes a pre-charging phase 821, a destruction phase 823, a read phase 825, and an amplification phase 827.

(1) Standby phase 810: A WL maintains a voltage of V0, and a BL, a BLN, and a PL maintain a voltage of Vw/2. In this case, an access transistor is turned off, voltages of all FGs are Vw/2, a voltage difference between two ends of the ferroelectric capacitor is 0, and a polarization state remains unchanged.

(2) Activation phase 820:

(a) Pre-charging phase 821: A voltage on the word line WL is set to an operating voltage (Vdd), so that the access transistor is turned on, and the voltage of V0 on the bit line BL is transferred to the floating gate FG. In addition, the BLN is also pre-charged by a PCH1 transistor to V0. The pre-charging operation in this embodiment of this application provides initial potential for the FG, to ensure subsequent activation of the ferroelectric capacitor. Because a polarization state of no ferroelectric capacitor is expected to change in this phase, a PL connected to an electrode plate on each ferroelectric capacitor maintains a semi-select voltage state of Vw/2.

(b) Destruction phase 823: The voltages of the BL and the BLN are pre-charged to Vref via a PCH0 transistor and the PCH1 transistor, to prepare for subsequent reading and amplification of the sense amplifier 710.

Destruction of the ferroelectric capacitor indicates that the WL is reduced to V0 to turn off the access transistor, so that the FG enters a suspended state, to ensure that the pre-charged voltage on the BL does not affect the voltage on the FG.

In this embodiment of this application, it is defined that when the information stored on the ferroelectric capacitor is 1, the ferroelectric capacitor is in a negative polarization state; and when the information stored on the ferroelectric capacitor is 0, the ferroelectric capacitor is in a positive polarization state. It is defined that a positive voltage difference between the PL and the FG indicates a positive polarization direction, and a negative voltage difference between the PL and the FG indicates a negative polarization direction.

A voltage on a PL on which a selected ferroelectric capacitor is located is set to Vw. If the selected ferroelectric capacitor is in the negative polarization state (information stored on the selected ferroelectric capacitor is 1), a voltage difference between the PL and an FG changes to the positive polarization direction, a polarization state of the selected ferroelectric capacitor changes from negative polarization to positive polarization. In this process, a charge on the selected ferroelectric capacitor enters the FG, so that a voltage of the FG increases to Vfg1.

If the selected ferroelectric capacitor is in a positive polarization state (the information stored on the selected ferroelectric capacitor is 0), because the voltage difference between the PL and the FG is still in the positive polarization direction, the polarization state of the ferroelectric capacitor does not change, and the voltage of the FG does not change, and remains Vfg0. Because a polarization state of no unselected ferroelectric capacitor is expected to change in this phase, a PL of each unselected ferroelectric capacitor maintains a semi-select voltage state of Vw/2.

Optionally, it may alternatively be defined that when the voltage difference between the PL and the FG is negative, it indicates the positive polarization direction; and it is defined when the voltage difference between the PL and the FG is positive, it indicates the negative polarization direction. This is not limited in this application.

It should be understood that the destruction phase in this application may alternatively be referred to as an activation phase, and the activation phase may alternatively be referred to as a destruction phase. A specific name should not be construed as a limitation on this application.

(c) Read phase 825: The WL is boosted to Vdd, the access transistor is turned on, and the FG shares the charge with the BL. Before charge sharing starts, a capacity on the FG is Cfg, and the voltage on the FG is Vfg. Before the charge sharing starts, a capacity on the BL is CBL, and the voltage on the BL is Vref. After the charge sharing is completed, the voltages on the FG and the BL change to Vrd.

When the information stored on the selected ferroelectric capacitor is 1, the voltage of the FG before the charge sharing starts is Vfg1, and after the charge sharing is completed, the voltages of the FG and the BL change to Vrd1. When the information stored on the selected ferroelectric capacitor is 0, the voltage of the FG before the charge sharing starts is Vfg0, and after the charge sharing is completed, the voltages of the FG and the BL change to Vrd0.

According to the law of charge conservation, the following two relational expressions are satisfied, where * indicates a multiplication operation:

$$Cfg*Vfg1+CBL*Vref=(Cfg+CBL)*Vrd1$$

$$Cfg*Vfg0+CBL*Vref=(Cfg+CBL)*Vrd0$$

(d) Amplification phase 827: In this phase, the sense amplifier 710 starts to operate, and the two ends of the sense amplifier 710 are respectively connected to the BL and the BLN. After charge sharing is performed on the BL, the voltage on the BL changes to Vrd0 or Vrd1, and the voltage on the BLN is still Vref. When the information "1" is read, the voltage on the BL is Vrd1, the voltage on the BLN is Vref, and Vrd1 is greater than Vref. In this case, the voltage on the BL is pulled by the sense amplifier 710 to Vw/2, and the voltage on the BLN is pulled by the sense amplifier 710 to V0. When the information "0" is read, the voltage on the BL is Vrd0, the voltage on the BLN is Vref, and Vrd0 is less than Vref. In this case, the voltage on the BL is pulled by the sense amplifier 710 to V0, and the voltage on the BLN is pulled by the sense amplifier 710 to Vw/2.

(3) Read/write phase 830: In this phase, the sense amplifier 710 always drives the BL and the BLN to V0 or Vw/2, to ensure a normal read/write operation.

(4) Writeback phase 840: The voltage on the WL is Vdd, and the access transistor is always in an on state. The ferroelectric capacitor is written back. A voltage difference of Vw needs to be established between the two ends of the ferroelectric capacitor, so that the polarization state of the ferroelectric capacitor can be changed, and writeback is completed. In the read/write phase 830, the voltage of the BL is always driven at V0 or Vw/2. In this case, the voltage of the PL is pulled to V0. Because the voltage difference is insufficient, the writeback cannot be completed. Therefore, in the writeback phase 840, the voltage of the SAN needs to be pulled from V0 to Vw/2, the voltage of the SAP is pulled from Vw/2 to Vw.

If the information "0" is read, the positive polarization state is not destructed in a destruction process of the ferroelectric capacitor. The voltage on the BL is pulled by the sense amplifier 710 to Vw/2, the voltage on the FG is transferred to Vw/2 through the BL, and the voltage on the PL is V0. In this case, the voltage difference between the PL and the FG is -Vw/2, and the ferroelectric capacitor continues to maintain the positive polarization state.

If the information "1" is read, the negative polarization state is changed to the positive polarization state in a destruction process of the ferroelectric capacitor. In the writeback phase 840, the voltage on the BL is pulled by the sense amplifier 710 to Vw, and the voltage on the FG is transferred to Vw through the BL. In this case, the voltage difference between the PL and the FG is -Vw, the ferroelectric capacitor is negatively polarized, and the writeback is completed.

(5) Exchange phase 850: After the writeback is completed, the WL continues to maintain the voltage of Vdd, the access transistor is turned on, and the voltage of the PL is pulled up to Vw/2. In this case, two ISO0s are turned off, and two ISO1s are turned on. The voltages of the BL and the BLN are exchanged. It should be understood that before the exchange phase, the two ISOls 1 are always in an off state.

If a return voltage in the writeback phase 840 is Vw/2, in the exchange phase, the voltage of the FG changes to Vw through the BL. If the return voltage in the writeback phase 840 is Vw, in the exchange phase, the voltage of the FG changes to Vw/2 through BL.

Table 1 shows voltage values of different lines in different phases of the read/write operation in this embodiment of this application. The voltage difference is a voltage difference of a ferroelectric capacitor at a selected FG and an unselected PL. For writeback of "1", the pre-charging phase 821 and the writeback phase 840 form bilateral disturbance. For writeback of "0", the pre-charging phase 821 and the exchange phase 850 form bilateral disturbance. In this embodiment of this application, unilateral disturbance in an entire access period is converted into bilateral disturbance, thereby reducing impact of the unilateral disturbance on a ferroelectric capacitor.

**Table 1 Voltages of different lines in different phases of the read/write operation**

| Phase | Information | BL | BLN | FG | PL | WL | Voltage difference |
|---|---|---|---|---|---|---|---|
| Standby 810 | / | $V_w/2$ | $V_w/2$ | $V_w/2$ | $V_w/2$ | $V_0$ | 0 |
| Pre-charging 821 | / | $V_0$ | $V_0$ | $V_0$ | $V_w/2$ | Vdd | $V_w/2$ |
| Destruction 823 | 0 | $V_{ref}$ | $V_{ref}$ | $V_{fg0}$ | Selected Vw | $V_0$ | / |
|  | 1 | $V_{ref}$ | $V_{ref}$ | $V_{fg1}$ | Unselected $V_w/2$ | $V_0$ | / |
| Read 825 | 0 | $V_{rd0}$ | $V_{ref}$ | $V_{rd0}$ | Selected Vw | Vdd | / |
|  | 1 | $V_{rd1}$ | $V_{ref}$ | $V_{rd1}$ | Unselected $V_w/2$ | Vdd | / |
| Amplification 827 | 0 | $V_0$ | $V_w/2$ | / | Selected Vw | Vdd | / |
|  | 1 | $V_w/2$ | $V_0$ | / | Unselected $V_w/2$ | Vdd | / |
| Read/Write 830 | 0 | $V_0$ | $V_w/2$ | / | $V_w/2$ | Vdd | / |
|  | 1 | $V_w/2$ | $V_0$ | / |  | Vdd | / |
| Writeback 840 | 0 | $V_w/2$ | Vw | $V_w/2$ | Selected $V_0$ | Vdd | 0 |
|  | 1 | Vw | $V_w/2$ | Vw | Unselected $V_w/2$ | Vdd | -Vw/2 |
| Exchange 850 | 0 | Vw | $V_w/2$ | Vw | $V_w/2$ | Vdd | -Vw/2 |
|  | 1 | $V_w/2$ | Vw | $V_w/2$ |  | Vdd | 0 |

It should be understood that the mTnC ferroelectric memories in the foregoing embodiments of this application are merely examples. The technical solutions provided in embodiments of this application may also be applied to a memory that is made of another material and that has a unilateral disturbance problem. The ferroelectric material should not be construed as a limitation on this application.

A person of ordinary skill in the art may be aware that the units and method steps described with reference to the examples in embodiments disclosed in this specification may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

All or some of the foregoing embodiments may be implemented by using software, hardware, firmware, or any combination thereof. When software is used to implement the embodiments, all or some of the embodiments may be implemented in a form of a computer program product. The computer program product includes one or more computer instructions. When the computer program instructions are loaded and executed on the computer, the procedure or functions according to embodiments of the present invention are all or partially generated. The computer may be a general-purpose computer, a dedicated computer, a computer network, or other programmable apparatuses. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber) or wireless (for example, infrared, microwave, or the like) manner. The computer-readable storage medium may be any usable medium accessible by the computer, or a data storage device, for example, a server or a data center, integrating one or more usable media. The usable medium may be a magnetic medium (for example, a floppy disk, a hard disk, or a magnetic tape), an optical medium (for example, a compact disc), a semiconductor medium (for example, a solid-state drive (solid-state drive, SSD)), or the like.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. A memory, comprising:

   a first memory cell, wherein the first memory cell is a memory cell selected for a read operation or a write operation;
   a sense amplifier, a first bit line, and a second bit line, wherein the first bit line is connected to the first memory cell and a first output of the sense amplifier, and the second bit line is connected to a second output of the sense amplifier;
   a first isolator, a second isolator, a third isolator, and a fourth isolator, wherein the first isolator is connected to the first bit line and the first output of the sense amplifier, the second isolator is connected to the second bit line and the second output of the sense amplifier, the third isolator is connected to the first bit line and the second output of the sense amplifier, and the fourth isolator is connected to the second bit line and the first output of the sense amplifier; and
   a controller, configured to: before writeback of the first memory cell is completed, turn on the first isolator and the second isolator, and turn off the third isolator and the fourth isolator; and after the writeback of the first memory cell is completed, turn off the first isolator and the second isolator, and turn on the third isolator and the fourth isolator.

2. The memory according to claim 1, wherein if before the writeback is completed, a voltage of the first bit line is a first positive voltage, and a voltage of the second bit line is a second positive voltage, after the writeback is completed, the voltage of the first bit line is the second positive voltage, and the voltage of the second bit line is the first positive voltage; or
   if before the writeback is completed, a voltage of the first bit line is a second positive voltage, and a voltage of the second bit line is the first positive voltage, after the writeback is completed, the voltage of the first bit line is the first positive voltage, and the voltage of the second bit line is the second positive voltage.

3. The memory according to claim 2, wherein the first positive voltage is equal to Vw/2, and the second positive voltage is equal to Vw, wherein Vw represents a write operation voltage of the first memory cell.

4. The memory according to any one of claims 1 to 3, wherein the first isolator is located between the third isolator and the sense amplifier, and the second isolator is located between the fourth isolator and the sense amplifier.

5. The memory according to any one of claims 1 to 4, wherein after the writeback is completed, a floating gate of the first memory cell has a same voltage as the first bit line, and first electrode plates of a plurality of capacitors of the first memory cell are connected to the floating gate.

6. The memory according to any one of claims 1 to 5, wherein the first isolator, the second isolator, the third isolator, and the fourth isolator each is an isolation (isolation, ISO) transistor.

7. The memory according to any one of claims 1 to 6, wherein the first bit line and the second bit line are connected to each other through a first conducting wire, the first isolator is located on the first bit line, the second isolator is located on the second bit line, and the third isolator and the fourth isolator are located on the first conducting wire.

8. A memory access method, wherein the method is applied to a memory comprising a first memory cell, a sense amplifier, a first bit line, a second bit line, a first isolator, a second isolator, a third isolator, a fourth isolator, and a controller, the first memory cell is a memory cell selected for a read operation or a write operation, the first bit line is connected to the first memory cell and a first output of the sense amplifier, the second bit line is connected to a second output of the sense amplifier, the first isolator is connected to the first bit line and the first output of the sense amplifier, the second isolator is connected to the second bit line and the second output of the sense amplifier, the third isolator is connected to the first bit line and the second output of the sense amplifier, the fourth isolator is connected to the second bit line and the first output of the sense amplifier, and the method comprises:

   before writeback of the first memory cell is completed, turning on, by the controller, the first isolator and the second isolator, and turning off the third isolator and the fourth isolator; and
   after the writeback of the first memory cell is completed, turning off, by the controller, the first isolator and the second isolator, and turning on the third isolator and the fourth isolator.

9. The method according to claim 8, wherein if before the writeback is completed, a voltage of the first bit line is a first positive voltage, and a voltage of the second bit line is a second positive voltage, after the writeback is completed, the voltage of the first bit line is the second positive voltage, and the voltage of the second bit line is the first positive voltage, or

if before the writeback is completed, a voltage of the first bit line is the second positive voltage, and a voltage of the second bit line is the first positive voltage, after the writeback is completed, the voltage of the first bit line is the first positive voltage, and the voltage of the second bit line is the second positive voltage.

10. The method according to claim 9, wherein the first positive voltage is equal to Vw/2, and the second positive voltage is equal to Vw, wherein Vw represents a write operation voltage of the first memory cell.

11. The method according to any one of claims 8 to 10, wherein after the writeback is completed, a floating gate of the first memory cell has a same voltage as the first bit line, and first electrode plates of a plurality of capacitors of the first memory cell are connected to the floating gate.

12. An integrated circuit, comprising the memory according to any one of claims 1 to 7.

13. An electronic device, comprising a circuit board and the memory according to any one of claims 1 to 7, wherein the memory is disposed on the circuit board and is electrically connected to the circuit board.

PL3
PL2
PL1
PL0

WL4
WL3
WL2
WL1
WL0

BL0
BL1
BL2
BL3
BL4

FIG. 1

Memory cell 210

FG

PL

WL

BL

Sense amplifier 230

WL

BLN

FIG. 2

FIG. 3

FIG. 4

FIG. 5

FIG. 6

FIG. 7

FIG. 8

FIG. 9

## INTERNATIONAL SEARCH REPORT

| International application No. |
|---|
| **PCT/CN2023/094138** |

**A.    CLASSIFICATION OF SUBJECT MATTER**

G11C11/22(2006.01)i

According to International Patent Classification (IPC) or to both national classification and IPC

**B.    FIELDS SEARCHED**

Minimum documentation searched (classification system followed by classification symbols)

IPC: G11C

Documentation searched other than minimum documentation to the extent that such documents are included in the fields searched

Electronic data base consulted during the international search (name of data base and, where practicable, search terms used)

CNABS; CNTXT; VEN; USTXT; EPTXT; WOTXT; CNKI; IEEE: 放大器, 隔离, 位线, 开关, 扰动, 极化, amplifier, isolate, bit line, switch, disturb, polarization

**C.    DOCUMENTS CONSIDERED TO BE RELEVANT**

| Category* | Citation of document, with indication, where appropriate, of the relevant passages | Relevant to claim No. |
|---|---|---|
| X | US 6091625 A (SIEMENS AKTIENGESELLSCHAFT) 18 July 2000 (2000-07-18) description, column 4, line 30-column 8, line 37, and figures 1-4 | 1-13 |
| A | CN 101266832 A (TSINGHUA UNIVERSITY) 17 September 2008 (2008-09-17) entire document | 1-13 |
| A | CN 114342075 A (HUAWEI TECHNOLOGIES CO., LTD.) 12 April 2022 (2022-04-12) entire document | 1-13 |
| A | US 2003206431 A1 (FISCH, David) 06 November 2003 (2003-11-06) entire document | 1-13 |
| A | US 2020075065 A1 (SK HYNIX INC. et al.) 05 March 2020 (2020-03-05) entire document | 1-13 |

☐ Further documents are listed in the continuation of Box C.        ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **18 July 2023** | **26 July 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
**Information on patent family members**

International application No.

**PCT/CN2023/094138**

| Patent document cited in search report | | | Publication date (day/month/year) | Patent family member(s) | | | Publication date (day/month/year) |
|---|---|---|---|---|---|---|---|
| US | 6091625 | A | 18 July 2000 | DE | 59913627 | D1 | 10 August 2006 |
| | | | | EP | 0991079 | A2 | 05 April 2000 |
| | | | | EP | 0991079 | B1 | 28 June 2006 |
| | | | | TW | 442788 | B | 23 June 2001 |
| | | | | DE | 19844402 | A1 | 30 March 2000 |
| | | | | DE | 19844402 | C2 | 14 November 2002 |
| CN | 101266832 | A | 17 September 2008 | CN | 101266832 | B | 02 June 2010 |
| CN | 114342075 | A | 12 April 2022 | WO | 2021056299 | A1 | 01 April 2021 |
| US | 2003206431 | A1 | 06 November 2003 | US | 6661695 | B2 | 09 December 2003 |
| US | 2020075065 | A1 | 05 March 2020 | US | 10950279 | B2 | 16 March 2021 |
| | | | | KR | 20200024555 | A | 09 March 2020 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210747729X